# EUROPÄISCHE PATENTSCHRIFT

(11) **EP 0 540 708 B1**
(45) Veröffentlichungstag und Bekanntmachung des Hinweises auf die Patenterteilung: **27.11.1996**
(21) Anmeldenummer: 92910042.8
(22) Anmeldetag: 13.05.1992
(51) Int. Cl.: E06B 9/24, H01L 31/042

(54) **BLENDSCHUTZVORRICHTUNG FÜR GEBÄUDE**
ANTI-DAZZLE DEVICE FOR BUILDINGS
DISPOSITIF ANTIEBLOUISSANT POUR BATIMENTS

(30) Priorität: 13.05.1991 DE 9105915 U
(43) Veröffentlichungstag der Anmeldung: 12.05.1993
(73) Patentinhaber: KRÖTZ, Thomas, D-72008 Tübingen (DE)
(72) Erfinder: KRÖTZ, Thomas, D-72008 Tübingen (DE)
(74) Vertreter: Strehl Schübel-Hopf Groening & Partner
(86) Internationale Anmeldenummer: DE9200385
(87) Internationale Veröffentlichungsnummer: WO9220893

(56) Entgegenhaltungen:
- EP-A- 0 371 000
- WO-A-86/01611
- DE-A- 3 523 244
- US-A- 4 187 123

## Beschreibung

Zur Vermeidung von Blendwirkungen und unerwünschter Aufheizung von Gebäudeinnenräumen sind lamellenartige Schutzvorrichtungen bekannt, die im Bereich der Fenster außerhalb der Fassade, zwischen zwei Fensterscheiben oder auch innerhalb der Räume angeordnet werden. Bei Außenanlagen verlaufen die einzelnen Lamellen gewöhnlich horizontal und sind um horizontale Achsen schwenkbar, so daß sich die Abblendwirkung je nach Sonnenstand regulieren läßt.

Zur Umwandlung von Sonnen- in elektrische Energie sind flächige photovoltaische Elemente bekannt, die bei Nutzung der Energie in Gebäuden herkömmlicherweise auf dem Gebäudedach fest installiert werden. Je nach Orientierung und Neigungswinkel des Dachs wird dabei die Energie der einfallenden Sonnenstrahlung mehr oder weniger optimal genutzt.

Die in Anspruch 1 gekennzeichnete Erfindung bezieht sich auf eine Vorrichtung, die die Wirkung eines Blendschutzes mit einer Ausnutzung der Sonnenenergie in der Weise kombiniert, daß beide Effekte in einer nach dem Sonnenstand regulierbaren Weise und gleichzeitig optimal erreicht werden. Bei starker Sonneneinstrahlung werden maximaler Blendschutz und maximale Ausbeute bei der Umwandlung in elektrische Energie durch derartige Einstellung der als Photovoltaik-Paneele ausgebildeten Lamellen erzielt, daß deren Flächen zur jeweiligen Lichteinfallsrichtung senkrecht stehen. Durch die natürliche allseitige Luftströmung um die Vorsatzfassade wird die elektrische Energieausbeute optimiert und die thermische Belastung der Gebäudefassade infolge direkten Sonnenlichteinfalls minimiert. Bei diffusem Licht, bei dem eine Energiegewinnung unabhängig von der Stellung der Photovoltaik-Paneele ohnehin nur minimal möglich ist, läßt sich auch die dann unerwünschte Tageslichtverschattung minimal halten.

Aus EP-A-0 371 000 ist eine Blendschutzvorrichtung mit mehreren um im wesentlichen horizontale Achsen schwenkbaren Lamellen, die als Photovoltaik-Elemente ausgebildet sind, bekannt, die jedoch nicht zur Anordnung vor einer Gebäudefassade, sondern auf dem Dach, insbesondere bei Gewächshäusern, bestimmt ist.

US-A-4,187,123 beschreibt eine Anordnung, bei der eine Gruppe von Solarzellen, die am Boden von eimerartigen Lichtkonzentratoren angeordnet sind, in einem Rahmen um jeweils zwei zueinander senkrechte Achsen schwenkbar gelagert sind, wobei auch der Rahmen um eine horizontale Achse geschwenkt werden kann. Als Blendschutzvorrichtung zur Anordnung vor einer Gebäudefassade ist die bekannte Anordnung weder bestimmt noch geeignet.

Aus US-A-4,137,098 und EP-A-0 028 820 sind Anordnungen bekannt, bei den zwischen zwei Fensterscheiben mehrere mit Photovoltaik-Elementen bestückte Lamellen schwenkbar untergebracht sind. Wegen ihrer abgeschlossenen Anordnung müssen diese Photovoltaik-Elemente gekühlt werden, was eine äußerst platzraubende und teuere Konstruktion ergibt. Gravierende Nachteile dieser Systeme bestehen ferner darin, daß die zur Nutzung der Sonnenenergie verfügbare Fläche auf die der Fenster beschränkt und eine Ausrichtung der Photovoltaik-Elemente nur begrenzt möglich ist.

Nach Anspruch 2 ist die erfindungsgemäß vorgehängte Blendschutz- und Energieerzeugungs-"Fassade" funktionsmäßig von der Gebäudefassade getrennt und erlaubt eine Ausnutzung der gesamten verfügbaren Fläche.

Die Weiterbildung der Erfindung nach Anspruch 3 und 4 gestattet zusätzlich zu einer Verstellung des Azimutwinkels eine Änderung in der Orientierung, woraus eine noch effizientere Blendschutzwirkung und Ausbeute der Sonnenstrahlung entsprechend dem sich über den Tagesverlauf ändernden Einstrahlwinkel resultiert. Gleichzeitig erleichtert die Zusammenfassung von Lamellengruppen in Leitergestellen die Wartung der Photovoltaik-Paneele

Die in Anspruch 5 angegebenen Merkmale führen zu dem weiteren Vorteil, daß sich bei Einsatz der erfindungsgemäßen Vorrichtung an einer nicht im wesentlichen nach Süden gewandten Fassade eine gegenseitige Beschattung der Lamellen/Photovoltaik-Paneele verringern läßt.

Die Weiterbildungen der Erfindung nach den Ansprüchen 6 bis 8 beziehen sich auf Maßnahmen zur gegebenenfalls automatischen Nachführung entsprechend Tageszeit und Sonnenstandshöhe.

Mit den Maßnahmen des Anspruchs 9 läßt sich die Tageslichtsteuerung in den hinter der Fassade liegenden Räumen verbessern.

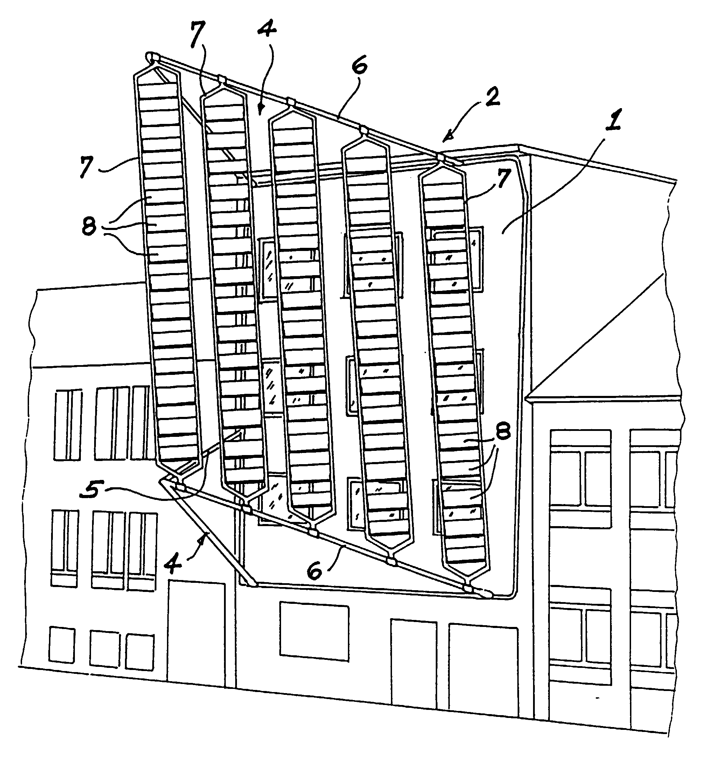

Ein Ausführungsbeispiel der erfindungsgemäßen Blendschutz/ Photovoltaik-Vorrichtung wird nachstehend anhand der Zeichnung näher erläutert.

In dem gezeigten Ausführungsbeispiel ist vor einer Gebäude-Fassade 1 ein aus Stahlrohren aufgebautes Traggerüst 2 angebracht. Das Traggerüst 2 umfaßt einen oberen und einen unteren jeweils dreieckigen Ausleger 4, die so dimensioniert und an dem Gebäude angebracht sind, daß sie den gewünschten Fassadenbereich abdecken. Die Ausleger 4 verlaufen parallel zueinander und steigen in Richtung von der Fassade 1 weg an, so daß der Platz im Verkehrsbereich vor dem Gebäude möglichst unbeeinträchtigt bleibt. Die äußere Spitze des unteren Auslegers 4 ist über ein Zugelement 5 gegenüber der Fassade 1 verstrebt. Ein weiteres (nicht gezeigtes) Zugelement kann zur Verankerung des oberen Auslegers 4 gegenüber dem Dach vorgesehen sein.

Zwischen den parallelen Schenkeln 6 der beiden Ausleger 4 sind mehrere Leitergestelle 7 angeordnet, die mit ihren Längsachsen parallel zueinander verlaufen. Die Längsachsen können senkrecht stehen oder auch, wie in der Zeichnung angedeutet, um einen gewissen Winkel so geneigt sein, daß die von den Leitern gebildeten Fächen etwas dem Himmel zugewandt sind. Jedes Leitergestell 7 besteht aus einem im wesentlichen rechteckigen, aus Rohrmaterial hergestellten Rahmen, der in der Mitte seiner oberen und unteren Enden um eine im wesentlichen senkrechte Achse schwenkbar an den Schenkeln 6 der Ausleger 4 gelagert ist.

In jedem Leitergestell ist eine Anzahl von rechteckigen Lamellen 8 mit zueinander parallelen horizontalen Längsachsen angeordnet. Jede Lamelle 8 ist an ihren beiden Enden an den senkrechten Rahmenteilen des betreffenden Leitergestells 7 um ihre horizontale Längsachse schwenkbar gelagert.

Die Lamellen 8 sind auf ihren Vorderflächen als Photovoltaik-Paneele ausgebildet, während ihre Rückflächen gut reflektierend sind. Die elektrischen Anschlüsse der Photovoltaik-Paneele sind in der Zeichnung nicht dargestellt; sie werden zur Erzielung der gewünschten Spannung in üblicher Weise so geschaltet, daß bei gegenseitiger Paneelverschattung der Leistungsabfall minimiert wird.

Sämtliche Leitergestelle 7 sind derart miteinander gekoppelt, daß die von ihnen jeweils gebildeten Flächen stets zueinander parallel stehen. Uber einen (nicht gezeigten) manuell oder elektrisch betätigten Antrieb lassen sich sämtliche Leitergestelle gemeinsam um ihre vertikalen Achsen auf den jeweils günstigsten Orientierungswinkel einstellen.

In ähnlicher Weise sind sämtliche Lamellen 8 jedes Leitergestells 7 so miteinander gekoppelt, daß ihre Flächen stets parallel zueinander stehen. Wiederum ist ein (nicht gezeigter) Antrieb vorgesehen, der es gestattet, sämtliche Lamellen 8 aller Leitergestelle 7 gemeinsam um ihre horizontalen Achsen auf den jeweils gewünschten Azimutwinkel auszurichten.

Für die Steuerung der Antriebe zur Verschwenkung der Leitergestelle 7 um ihre vertikalen Achsen sowie der Lamellen 8 um ihre horizontalen Achsen kann eine gemeinsame Steuerung vorgesehen sein, die die Lamellenflächen derart nachführt, daß sie jeweils - so weit wie möglich - senkrecht zur Einfallsrichtung des Sonnenlichts stehen. Die Nachführung kann vollautomatisch mittels einer Zeituhr und einem vorgegebenen, nach Jahreszeit variierenden Programm oder auch unter direkter Messung des Sonnenlicht-Einfallswinkels erfolgen. In einer Variante kann die Steuerung auch mit dem Signal einer innerhalb des Gebäudes angeordneten Lichtzelle arbeiten.

In der Zeichnung ist angenommen, daß die Gebäudefassade 1 nicht nach Süden gewandt ist. Die dreieckigen Ausleger 4 sind dabei so gestaltet, daß ihre Schenkel 6 eine mehr nach Süden gewandte Fläche definieren. Auf diese Weise wird erreicht, daß die Lamellen 8 der einzelnen Leitergestelle 7 im Laufe des Tages einander möglichst wenig beschatten.

Die Lamellen 8 können auch so ausgerichtet werden, daß durch die reflektierende Rückfläche jeder Lamelle das von der Vorderfläche der jeweils darunter befindlichen Lamelle abgestrahlte Sonnenlicht gegen die Fassade 1 und in die dahinter befindlichen Räume gerichtet wird. Dabei kann die Nachführung der Lamellenstellung so erfolgen, daß in erster Linie nicht auf maximale Stromgewinnung sondern auf optimale Beleuchtung der Räume geregelt wird.

Bei trübem Wetter und diffusen Lichtverhältnissen kann es zweckmäßig sein, die Steuerung abzuschalten und die Lamellen in einer festen Stellung zu arretieren oder die Steuerung so vorzunehmen, daß die Anlage zu einer möglichst geringen Verschattung führt und möglichst viel Diffuslicht auf die Fassade trifft. Zur Sturmsicherung wird eine Arretierung der Lamellen 8 in horizontaler Ausrichtung zweckmäßig sein.

## Patentansprüche

1. Vor einer Gebäudefassade angeordnete Blendschutzvorrichtung mit mehreren um im wesentlichen horizontale Achsen schwenkbaren Lamellen (8), dadurch gekennzeichnet, daß die Lamellen (8) als Photovoltaik-Elemente ausgebildet und jeweils mehrere Lamellen (8) übereinander in einem Leitergestell (7) mit im wesentlichen senkrecht verlaufender Längsachse angeordnet sind.

2. Vorrichtung nach Anspruch 1, dadurch gekennzeichnet, daß jeweils mehrere übereinander angeordnete Lamellen (8) zu Gruppen zusammengefaßt sind, die über einen wesentlichen Teil der Gebäudefassade unabhängig von darin vorhandenen Fenstern verlaufen.

3. Vorrichtung nach Anspruch 1 oder 2, dadurch gekennzeichnet, daß jedes Leitergestell (7) um eine im wesentlichen senkrechte Achse schwenkbar gelagert ist.

4. Vorrichtung nach Anspruch 3, dadurch gekennzeichnet, daß mehrere Leitergestelle (7) jeweils um ihre im wesentliche senkrechte Achse schwenkbar und mit diesen Achsen parallel zueinander in einem an der Gebäudefassade (1) befestigbaren Traggerüst (2, 4, 6) gelagert sind.

5. Vorrichtung nach Anspruch 4, dadurch gekennzeichnet, daß das Traggerüst (2, 4, 6) so an der Gebäudefassade (1) angeordnet ist, daß seine Ebene mit der Fassade (1) in der Horizontalen einen Winkel bildet.

6. Vorrichtung nach einem der Ansprüche 3 bis 5, gekennzeichnet durch fernsteuerbare Dreheinrichtungen zur Änderung der Winkelstellung der Lamellen (8) um die horizontalen und/ oder die vertikalen Achsen.

7. Vorrichtung nach Anspruch 6, dadurch gekennzeichnet, daß die Dreheinrichtungen von einer innerhalb des Gebäudes befindlichen Photozelle steuerbar sind.

8. Vorrichtung nach Anspruch 6, dadurch gekennzeichnet, daß die Dreheinrichtungen entsprechend dem Sonnenlicht-Einfallswinkel steuerbar sind.

9. Vorrichtung nach einem der Ansprüche 1 bis 8, dadurch gekennzeichnet, daß die Unterseiten der Lamellen (8) reflektierend ausgebildet sind.

## Claims

1. Anti-dazzle device arranged in front of a facade of a building, including a plurality of louver blades (8) pivotal about substantially horizontal axes, **characterised** in that the louver blades (8) are formed as photo-voltaic elements, a plurality of louver blades (8) being disposed above each other in a ladder-type frame (7) having a substantially vertically extending longitudinal axis.

2. The device of claim 1, characterised in that pluralities of louver blades (8) disposed above each other are combined to form groups which extend across a substantial part of the building facade independent of any windows provided therein.

3. The device of claim 1 or 2, characterised in that each ladder-type frame (7) is mounted for pivotal movement about a substantially vertical axis.

4. The device of claim 3, characterised in that a plurality of ladder-type frames (7) are mounted in a support frame (2, 4, 6) adapted to be fixed to the building facade (1), each ladder-type frame being pivotal about its substantially vertical axis, with these axes extending parallel to each other.

5. The device of claim 4, characterised in that the support frame (2, 4, 6) is so disposed on the building facade (1) that its plane forms an angle with the facade (1) in the horizontal projection.

6. The device of any of claims 3 to 5, characterised by remote controllable rotating means for varying the angular position of the louver blades (8) about the horizontal and/or vertical axes.

7. The device of claim 6, characterised in that the rotating means is adapted to be controlled by a photo-cell disposed inside the building.

8. The device of claim 6, characterised in that the rotating means is adapted to be controlled in accordance with the angle of incidence of sunlight.

9. The device of any of claims 1 to 8, characterised in that the lower sides of the louver blades (8) are made reflective.

## Revendications

1. Dispositif antiéblouissant disposé devant la façade d'un bâtiment avec plusieurs lamelles (8) pivotant autour d'axes sensiblement horizontaux, **caractérisé** en ce que les lamelles (8) sont formées comme éléments photovoltaïques et plusieurs lamelles (8) sont disposées l'une sur l'autre dans un échafaudage-échelle (7) doté d'un axe longitudinal sensiblement vertical.

2. Dispositif selon la revendication 1, caracterisé par plusieurs lamelles (8) superposées pour former des groupes lesquels s'étendent sur une partie essentielle de la façade du bâtiment indépendamment des fenêtres y existantes.

3. Dispositif selon l'une ou l'autre des revendications 1 et 2, caractérisé en ce que chaque échafaudage-échelle (7) est en position pivotante autour d'un axe sensiblement vertical.

4. Dispositif selon revendication 3, caractérisé par plusieurs échafaudages-échelles (7) montés chacun sur un cadre porteur (2, 4 ,6 ) pouvant être fixé sur la façade du bâtiment (1), chaque échafaudage-échelle pivotant autour de son axe sensiblement vertical, avec ces axes s'étendant parallèlement l'un à l'autre.

5. Dispositif selon revendication 4, caractérisé en ce que le cadre porteur (2, 4, 6) est disposé sur la façade (1) de telle façon que son plan forme un angle avec la façade (1) en projection horizontale.

6. Dispositif selon l'une quleconque des revendications 3 à 5, caractérisé par des dispositifs rotatifs télécommandables pour faire varier la position angulaire des lamelles (8) autour des axes horizontaux et/ou verticaux.

7. Dispositif selon revendication 6, caractérisé en ce que les dispositifs rotatifs peuvent être commandés par une cellule photo-électrique située à l'intérieur du bâtiment.

8. Dispositif selon revendication 6, caractérisé en ce que les dispositifs rotatifs peuvent être commandés en fonction de l'angle d'incidence de la lumière du soleil.

9. Dispositif selon l'une quelconque des revendications 1 à 8, caractérisé en ce que les faces arriéres des lamelles (8) sont réfléchissant.
